# EUROPEAN PATENT APPLICATION

(11) **EP 4 852 694 A1**
(43) Date of publication of application: **09.12.2026**
(21) Application number: 25769267.3
(22) Date of filing: 03.03.2025
(51) Int. Cl.: H10P 72/00, H10P 72/76

(54) **SUPPORT DEVICE, HEATER AND SEMICONDUCTOR PROCESS APPARATUS**

(30) Priority: 15.03.2024 CN 202410302921
(71) Applicant: Beijing NAURA Microelectronics Equipment Co., Ltd., Beijing 100176 (CN)
(72) Inventor: ZHANG, Yunlong, Beijing 100176 (CN); LIU, Hongli, Beijing 100176 (CN)
(74) Representative: Cohausz & Florack
(86) International application number: PCT/CN2025/080148
(87) International publication number: WO 2025/190095

(57) **Abstract**

Disclosed are a support device, a heater, and a semiconductor process apparatus. The support device disclosed is applied to a heater of a semiconductor process apparatus, to support a heater body of the heater, where the support device disclosed includes a plurality of support units; the plurality of support units are arranged circumferentially, and each support unit includes a plurality of insulating support bodies sequentially stacked; and a first end portion of each insulating support body is provided with a first limiting portion, and a second end portion, oriented away from the first end portion, of the insulating support body is provided with a second limiting portion; and in each support unit, the first limiting portion of one of any two adjacent insulating support bodies and the second limiting portion of the other of the two adjacent insulating support bodies are in limiting engagement in a first axial direction, and each insulating support body is configured for supporting engagement with the heater body, where the first axial direction is parallel to a stacking direction of the plurality of insulating support bodies. The solution can solve the problem that a heater body support device in the related art is likely to cause deformation of a heater body after thermal expansion and contraction deformation.

## Description

### TECHNICAL FIELD

The present disclosure relates to the technical field of semiconductor apparatuses, and in particular, to a support device, a heater, and a semiconductor process apparatus.

### BACKGROUND

In a process of fabricating integrated circuits using semiconductor process apparatuses (for example, a vertical furnace apparatus), various processes such as oxidation, annealing, and film growth are typically required. These thermal processes are generally performed at particular temperatures. As a result, the semiconductor process apparatus requires a heater device.

In the related art, the heater device mainly adopts a spirally wound heater body, and the heater body is supported by a heater body support device. To prevent the heater body from overlapping and short-circuiting between adjacent spiral segments, the heater body support device is provided with an insulator between adjacent spiral segments, to ensure the pitch of the heater body. Generally, the one ends of the insulators are connected to the heater body to support the heater body, and a through rod of the heater body support device sequentially passes through holes in the other ends of a plurality of insulators in the same row (the direction of a spiral axial direction of the heater body), to mount the plurality of insulators in the same row. The one end of the through rod is fixed, and the other end of the through rod can freely expand and contract. Moreover, particular clearance is reserved between the through rod and the through hole of the insulator, to adapt to deformation of thermal expansion and contraction of the through rod.

However, in the heating state, the heater body extends due to heating, to press on the edge of the insulator. As a result, the through rod and the through hole of the insulator become non-concentric, the friction between the through rod and the through hole of the insulator is increased, the deformation of the thermal expansion and contraction of the through rod cannot be absorbed, and the through rod is likely to deform. After repeated accumulation, the through rod severely deforms. The deformed through rod is likely to press the heater body to deform, to make the heater body leave a support area of the insulator. The overlapping and short-circuiting of the heater body is likely to occur between adjacent spiral segments and the heater device becomes unusable.

### SUMMARY

The present disclosure discloses a support device, a heater, and a semiconductor process apparatus, to solve the problem that a heater body support device in the related art is likely to cause deformation of a heater body after thermal expansion and contraction deformation.

To solve the technical problem, the present disclosure is implemented as follows:

In the first aspect, the present disclosure discloses a support device. The support device is applied to a heater of a semiconductor process apparatus, to support a heater body of the heater, where the support device includes a plurality of support units; the plurality of support units are arranged circumferentially, and each support unit includes a plurality of insulating support bodies sequentially stacked; and a first end portion of each insulating support body is provided with a first limiting portion, and a second end portion, oriented away from the first end portion, of the insulating support body is provided with a second limiting portion; and

in each support unit, the first limiting portion of one of any two adjacent insulating support bodies and the second limiting portion of the other of the two adjacent insulating support bodies are in limiting engagement in a first axial direction, and each insulating support body is configured for supporting engagement with the heater body, where the first axial direction is parallel to a stacking direction of the plurality of insulating support bodies.

In a second aspect, the present disclosure further discloses a heater. The heater includes a heater body and the support device described in the first aspect.

In a third aspect, the present disclosure further discloses a semiconductor process apparatus. The semiconductor process apparatus disclosed includes a reaction chamber and the heater described in the second aspect, where the heater is configured to heat the reaction chamber.

The technical solution adopted in the present disclosure can achieve the following technical effects:
According to the support device disclosed by embodiments of the present disclosure, each support unit is arranged to include the plurality of insulating support bodies, the first end portion of each insulating support body is provided with the first limiting portion, and the second end portion, oriented away from the first end portion, of the insulating support body is provided with the second limiting portion. In each support unit, the first limiting portion of one of any two adjacent insulating support bodies and the second limiting portion of the other of the two adjacent insulating support bodies are in limiting engagement in the first axial direction. Thus, the plurality of insulating support bodies in each support unit are sequentially stacked and connected to each other. Since the embodiments of the present disclosure adopt a connection structure in which the first limiting portion and the second limiting portion are in limiting engagement in the first axial direction instead of a structure in which a plurality of insulators are connected through a through rod in the related art, a case that a through rod deforms to press the heater body to deform is avoided, and the problem that the support device causes deformation of the heater body after thermal expansion and contraction deformation can be further avoided.

### BRIEF DESCRIPTION OF DRAWINGS

FIG. 1 is a schematic structural diagram of an insulating support body according to an embodiment of the present disclosure, in which p denotes a first axial direction, q denotes a second axial direction, and r denotes a third axial direction;
FIG. 2 is a sectional view taken along a dotted line in FIG. 1;
FIG. 3 is a schematic diagram of mounting of two adjacent insulating support bodies according to an embodiment of the present disclosure;
FIG. 4 is a schematic diagram of engagement between insulating support bodies and a mounting guide rail according to an embodiment of the present disclosure;
FIG. 5 is a top view of engagement between an insulating support body and a mounting guide rail according to an embodiment of the present disclosure;
FIG. 6 is a schematic structural diagram of a thermal insulation member according to an embodiment of the present disclosure;
FIG. 7 is a schematic structural diagram of a cambered thermal insulation subunit according to an embodiment of the present disclosure;
FIG. 8 is a schematic diagram of engagement between sliding portions and sliding engagement portions according to an embodiment of the present disclosure;
FIG. 9 is a schematic diagram of an enlarged view of engagement between a sliding portion and a sliding engagement portion according to an embodiment of the present disclosure;
FIG. 10 is a schematic structural diagram of a support base;
FIG. 11 is a schematic structural diagram of a support unit mounted to a support base;
FIG. 12 is a schematic structural diagram of mounting guide rails mounted to a support base;
FIG. 13 is a schematic structural diagram of a heater;
FIG. 14 is a schematic top view of the heater in FIG. 13; and
FIG. 15 is a schematic diagram of supporting engagement between an insulating support body and a heater body in a case that an inclination angle of a support surface, supporting the heater body, of the insulating support body is equal to a spiral angle of a spiral structure.

Description of reference numerals:
100-support unit, 101-deformation gap, 110-insulating support body, 111-first limiting protrusion, 112-first limiting groove, 113-support recess, 114-guide rail engagement portion, 114a-second limiting groove
200-mounting guide rail, 210-first mounting groove, 211-second limiting protrusion,
300-thermal insulation member, 310-cambered thermal insulation subunit, 311-second mounting groove,
400-sliding engagement portion, 410-sliding hole,
500-support base, 510-annular stepped structure, 511-stepped surface,
700-heater body,
800-sliding portion,
910-top support member, and 920-lead terminal.

### DETAILED DESCRIPTION

In order to make objectives, technical solutions and advantages of the present disclosure clearer, the technical solutions of the present disclosure will be clearly and completely described below in conjunction with the particular embodiments and corresponding accompanying drawings of the present disclosure. Apparently, the embodiments described are merely some embodiments rather than all embodiments of the present disclosure. All other embodiments derived by those of ordinary skill in the art from the embodiments of the present disclosure without creative efforts should fall within the protection scope of the present disclosure.

The technical solutions disclosed in the embodiments of the present disclosure will be described in detail in conjunction with the accompanying drawings below.

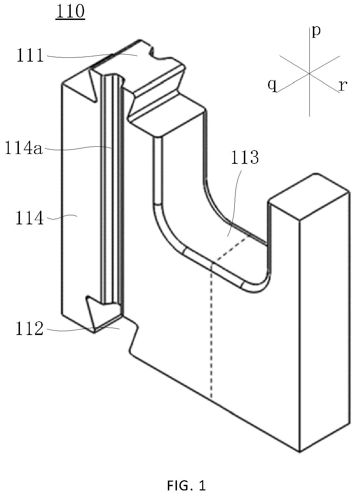

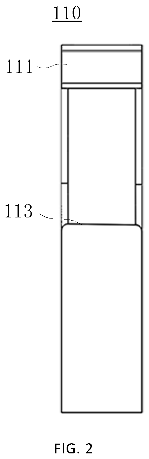

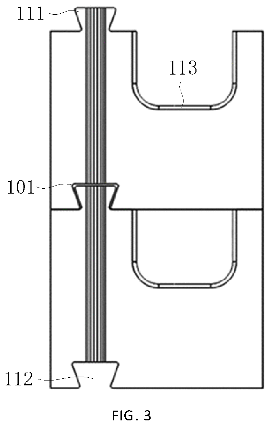

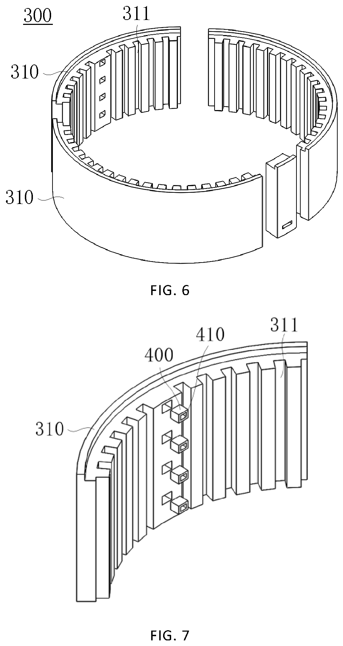

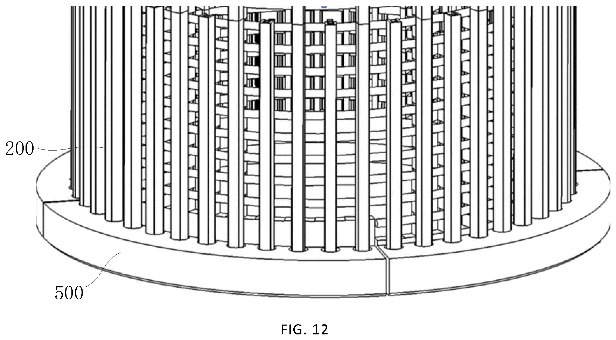

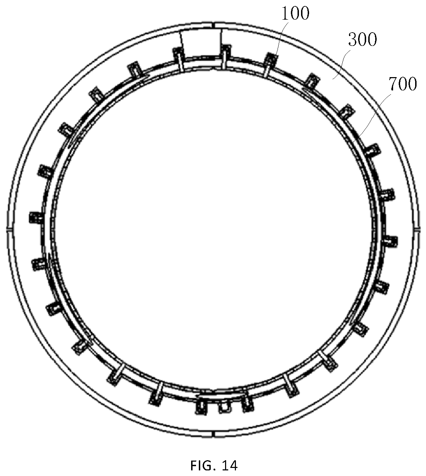

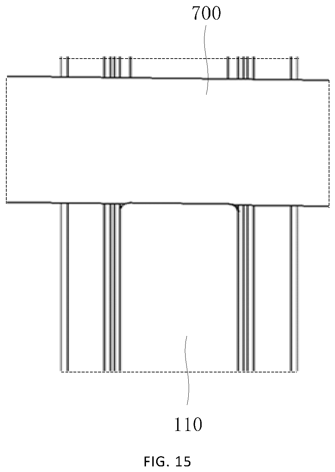

With reference to FIG. 1 to FIG. 15, the embodiments of the present disclosure disclose a support device. The support device is applied to a heater of a semiconductor process apparatus, to support a heater body 700 of the heater.

The support device disclosed includes a plurality of support units 100. The plurality of support units 100 are arranged circumferentially. Each support unit 100 includes a plurality of insulating support bodies 110 sequentially stacked. With reference to FIG. 1 to FIG. 3, a first end portion of each insulating support body 110 is provided with a first limiting portion, and a second end portion, oriented away from the first end portion, of the insulating support body 110 is provided with a second limiting portion.

In each support unit 100, the first limiting portion of one of any two adjacent insulating support bodies 110 and the second limiting portion of the other of the two adjacent insulating support bodies are in limiting engagement in a first axial direction (for example, the direction denoted by P in FIG. 1). Thus, the two adjacent insulating support bodies 110 are connected to limit separation of any two adjacent insulating support bodies 110 in the first axial direction.

The insulating support body 110 is configured for supporting engagement with the heater body 700. The first axial direction is parallel to a stacking direction of the plurality of insulating support bodies 110. The first limiting portion and the second limiting portion may be located at two end portions, oriented away from each other, of the insulating support body 110 in the first axial direction. That is, the first end portion and the second end portion of the insulating support body 110 are oriented away from each other in the first axial direction.

It should be noted that the heater body 700 generally has a spiral structure or a structure including a plurality of annular structures. In each support unit 100, the insulating support body 110 is correspondingly arranged between any two adjacent spiral segments or any two adjacent annular structures of the heater body 700, to avoid overlapping and short-circuiting between any two adjacent spiral segments or any two adjacent annular structures. In addition, the insulating support body 110 is configured to support a corresponding spiral segment or annular structure. The plurality of support units 100 are arranged around the heater body 700, to jointly support the heater body 700.

In the support device according to the embodiment of the present disclosure, each support unit 100 is arranged in a structure including the plurality of insulating support bodies 110, the first end portion of each insulating support body 110 is provided with the first limiting portion, and the second end portion, oriented away from the first end portion, of the insulating support body 110 is provided with the second limiting portion. In each support unit 100, the first limiting portion of one of any two adjacent insulating support bodies 110 and the second limiting portion of the other of the two adjacent insulating support bodies are in limiting engagement in the first axial direction. Thus, the plurality of insulating support bodies 110 in each support unit are sequentially stacked and connected to each other. Since the embodiments of the present disclosure adopt a connection structure in which the first limiting portion and the second limiting portion are in limiting engagement in the first axial direction instead of a structure of connecting a plurality of insulators through a through rod in the related art, a case that a through rod deforms to press the heater body 700 to deform is avoided, and the problem that the support device causes deformation of the heater body after thermal expansion and contraction deformation can be further avoided.

Specifically, one of the first limiting portion and the second limiting portion may be a snap, and the other of the first limiting portion and the second limiting portion may be a snap-fit engagement portion. The snap and the snap-fit engagement portion may be arranged at the same side of the insulating support body 110. The snap of one of any two adjacent insulating support bodies 110 in each support unit 100 may be snap-fitted to the snap-fit engagement portion of the other of the two adjacent insulating support bodies, such that two adjacent insulating support bodies 110 may be in limiting engagement in the first axial direction.

In another implementation, one of the first limiting portion and the second limiting portion may be a first limiting protrusion 111, and the other of the first limiting portion and the second limiting portion may be a first limiting groove 112. In each support unit 100, the first limiting protrusion 111 of one of any two adjacent insulating support bodies 110 and the first limiting groove 112 of the other of the two adjacent insulating support bodies may be in inserting engagement, and may be in limiting engagement in the first axial direction. In each support unit 100, the first limiting protrusion 111 of one of any two adjacent insulating support bodies 110 and the first limiting groove 112 of the other of the two adjacent insulating support bodies may be in inserting engagement in a direction perpendicular to the first axial direction. It is clear that the first limiting portion and the second limiting portion may further have other structures, and the first limiting portion and the second limiting portion are not specifically limited by the embodiments of the present disclosure.

To make the connection of the insulating support bodies 110 in each support unit 100 more stable, in some embodiments, in each support unit 100, the first limiting portion of one of any two adjacent insulating support bodies 110 and the second limiting portion of the other of the two adjacent insulating support bodies are in inserting engagement in a second axial direction (for example, a direction denoted by q in FIG. 1), and the first limiting portion and the second limiting portion may be further in limiting engagement in a third axial direction. The third axial direction may be parallel to a direction (for example, a direction denoted by r in FIG. 1) in which a corresponding insulating support body 110 points towards a center of circumferential arrangement of the plurality of support units 100. That is, the third axial directions corresponding to different insulating support bodies 110 in each support unit 100 are different. The first axial direction, the second axial direction, and the third axial direction are perpendicular to one another.

In the support device according to the embodiment of the present disclosure, the first limiting portion of one of two adjacent insulating support bodies 110 and the second limiting portion of the other of two adjacent insulating support bodies are further in limiting engagement in the third axial direction, and are merely in inserting engagement in the second axial direction. Thus, two adjacent insulating support bodies 110 are limited in the first axial direction and the third axial direction, making the connection of the insulating support bodies 110 in each support unit 100 more stable.

Further, the first limiting portion of one of two adjacent insulating support bodies 110 and the second limiting portion of the other of two adjacent insulating support bodies may be further in limiting engagement in a rotation direction around the second axial direction. A support portion, configured to support the heater body 700, of the insulating support body 110 may be spaced apart with the first limiting portions in the third axial direction. The support portion, configured to support the heater body 700, of the insulating support body 110 may be located at a side, close to the center of circumferential arrangement of the plurality of support units 100, of the first limiting portion. When the heater body 700 presses the insulating support bodies 110 by gravity, the first limiting portion and the second limiting portion of two adjacent insulating support bodies 110 are in limiting engagement in the third axial direction and in limiting engagement in the rotation direction around the second axial direction. Thus, the insulating support bodies 110 do not move substantially in the third axial direction or rotate substantially in the rotation direction around the second axial direction, and the insulating support bodies 110 support the heater body 700 more stably.

For example, in the implementation where one of the first limiting portion and the second limiting portion is the first limiting protrusion 111 and the other of the first limiting portion and the second limiting portion is the first limiting groove 112, a width of a top end of the first limiting protrusion 111 may be greater than a width of a bottom end of the first limiting protrusion 111 in the third axial direction, and a contour shape of the first limiting groove 112 may be adapted to a shape of the first limiting protrusion 111. In a case that the first limiting protrusion 111 and the first limiting groove 112 are in inserting engagement in the second axial direction, the first limiting protrusion 111 and the first limiting groove 112 may be in limiting engagement in the first axial direction and the third axial direction, and in limiting engagement in the rotation direction around the second axial direction. Specifically, the first limiting protrusion 111 may be a trapezoidal structure, or a structure formed by stacking and connecting a plurality of trapezoidal structures, or a special-shaped structure formed by sequentially distributing a plurality of protrusions and recesses. A specific structure of the first limiting protrusion 111 is not limited by the embodiments of the present disclosure.

To support the heater body 700 more stably, in some embodiments, each insulating support body 110 may be provided with, in the first axial direction, a support recess 113 having an upward opening, and a bottom of the support recess 113 may be configured to support the heater body 700. The support recess 113 may be provided in the first end portion of the insulating support body 110, and the first end portion of the insulating support body 110 is located above the second end portion of the insulating support body 110.

In the support device according to the embodiment of the present disclosure, the support recess 113 is provided, and the bottom of the support recess 113 is configured to support the heater body 700. Thus, the insulating support body 110 supports the heater body 700 more stably, and the heater body 700 can be prevented from disengaging from the insulating support body 110 after thermal deformation.

To prevent the heater body 700 from disengaging from the support recess 113 after thermal deformation, in each support unit 100 in some embodiments, the second end portion of any insulating support body 110 may block the opening of the support recess 113 of an adjacent insulating support body 110. Thus, the heater body 700 can be prevented from separating from the support recess 113 after thermal deformation.

To adapt to displacement caused by thermal expansion and contraction deformation of the heater body 700 after heating, in some embodiments, the support recess 113 may be a strip-shaped recess structure, and an extension direction of the strip-shaped recess structure is parallel to the third axial direction corresponding to a corresponding insulating support body 110. Thus, the support recess 113 can adapt to the displacement caused by thermal expansion and contraction deformation of the heater body 700 after heating.

To increase a support area of the insulating support body 110 for supporting the heater body 700, and alleviate deformation of the heater body 700 under the action of gravity after thermal deformation, in some embodiments, the heater body 700 has a spiral structure, and an inclination angle of a support surface, supporting the heater body 700, of the insulating support body 110 may be equal to a spiral angle of the spiral structure. Thus, the support surface, supporting the heater body 700, of the insulating support body 110 can be completely attached to the heater body 700, the support area of the insulating support body 110 for supporting the heater body 700 can be increased, and the deformation of the heater body 700 under the action of gravity after thermal deformation can be further alleviated.

It should be noted that the inclination angle of the support surface, supporting the heater body 700, of the insulating support body 110 refers to an inclination angle of the support surface relative to the horizontal plane.

To reduce stress at an edge position of the support surface when supporting the heating body 700, in some embodiments, two edges of the support surface in a direction in which the heater body 700 passes therethrough are rounded edges. Thus, stress concentration at the edge position of the support surface when supporting the heating body 700 can be alleviated.

In a case that the first limiting portion is the first limiting protrusion 111 and the second limiting portion is the first limiting groove 112, in some embodiments, a deformation gap 101 is provided between the first limiting protrusion 111 and the first limiting groove 112, to make the insulating support bodies 110 in the same support unit 100 better adapt to thermal expansion and contraction.

To improve mounting stability of the plurality of insulating support bodies 110 in the same support unit 100, with reference to FIG. 1, FIG. 4 to FIG. 5, in some embodiments, the support device may further include a mounting guide rail 200 extending in the first axial direction. The insulating support body 110 may include a guide rail engagement portion 114, the plurality of insulating support bodies 110 of each support unit 100 may be mounted through the guide rail engagement portions 114 on the same mounting guide rail 200 in the first axial direction, and the guide rail engagement portion 114 and the mounting guide rail 200 are in limiting engagement in a preset plane. The preset plane is perpendicular to the first axial direction. That is, the guide rail engagement portion 114 may merely move in the first axial direction without substantial movement relative to the mounting guide rail 200 in any direction within the preset plane. The mounting guide rail 200 may be made of a ceramic material, and the mounting guide rail 200 may be further made of other materials clearly. The material of the mounting guide rail 200 is not specifically limited by the embodiments of the present disclosure.

According to the support device according to the embodiment of the present disclosure, by arranging the mounting guide rail 200, the plurality of insulating support bodies 110 of each support unit 100 may be mounted through the guide rail engagement portions 114 on the same mounting guide rail 200 in the first axial direction, and the guide rail engagement portion 114 and the mounting guide rail 200 are in limiting engagement in the preset plane. Thus, the mounting stability of the plurality of insulating support bodies 110 in the same support unit 100 can be improved.

Specifically, the guide rail engagement portion 114 may be a snap-in slot having a retaining flange, and the retaining flange may be located at an opening of the snap-in slot. The mounting guide rail 200 may be a protruding rail extending in the first axial direction. The snap-in slot may be sleeved around the protruding rail in the first axial direction, and the retaining flange and the protruding rail are in limiting engagement in a direction of the opening of the snap-in slot. Thus, the protruding rail can merely move along the snap-in slot in the first axial direction.

In another implementation, the mounting guide rail 200 may be provided with a first mounting groove 210 extending in the first axial direction, and the guide rail engagement portion 114 and the first mounting groove 210 are in inserting engagement in the first axial direction. The mounting guide rail 200 may include a third limiting portion. The guide rail engagement portion 114 may include a fourth limiting portion, and the third limiting portion and the fourth limiting portion may be in limiting engagement in a direction (the direction of the opening) from a bottom of the first mounting groove 210 to an opening of the first mounting groove 210. Thus, a structure of the mounting guide rail 200 is simple.

It should be noted that a side wall of the first mounting groove 210 and the guide rail engagement portion 114 may be in limiting engagement in the second axial direction, and the direction from the bottom of the first mounting groove 210 to the opening of the first mounting groove 210 may be the third axial direction. The first axial direction, the second axial direction, and the third axial direction are perpendicular to one another.

Further, one of the side wall of the first mounting groove 210 and the guide rail engagement portion 114 may be provided with a second limiting protrusion 211, and the other of the side wall of the first mounting groove and the rail engagement portion may be provided with a second limiting groove 114a. The second limiting protrusion 211 or the second limiting groove 114a located in the side wall of the first mounting groove 210 extends in the first axial direction. In a case that the guide rail engagement portion 114 and the first mounting groove 210 are in inserting engagement in the first axial direction, the second limiting protrusion 211 and the second limiting groove 114a may be in sliding engagement in the first axial direction, and in limiting engagement in the direction from the bottom of the first mounting groove 210 to the opening of the first mounting groove 210. The third limiting portion includes one of the second limiting protrusion 211 and the second limiting groove 114a, and the fourth limiting portion includes the other of the second limiting protrusion 211 and the second limiting groove 114a.

In the support device according to the embodiment of the present disclosure, the third limiting portion is set as one of the second limiting protrusion 211 and the second limiting groove 114a, and the fourth limiting portion is set as the other of the second limiting protrusion 211 and the second limiting groove 114a. Thus, the third limiting portion and the fourth limiting portion have simple structures and are in stable engagement.

In some embodiments, the first limiting portion and the second limiting portion may be arranged opposite each other in the first axial direction, and are arranged in the guide rail engagement portion 114. The second limiting protrusion 211 or the second limiting groove 114a located in the guide rail engagement portion 114 extends to the first limiting portion and the second limiting portion in turn in the first axial direction.

In the support device according to the embodiment of the present disclosure, the first limiting portion and the second limiting portion are arranged in the guide rail engagement portion 114. Thus, the first limiting portion and the second limiting portion can be hidden in the mounting guide rail 200, and the mounting guide rail 200 can protect the first limiting portion and the second limiting portion.

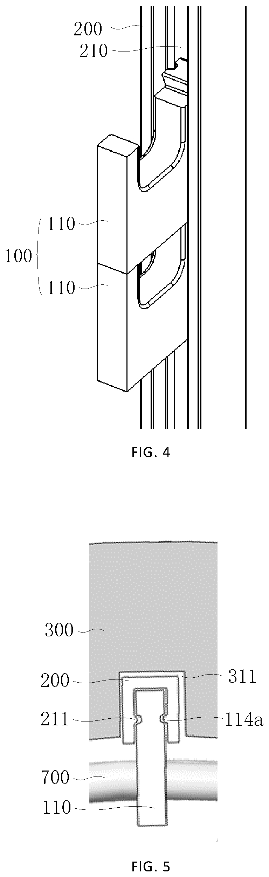

To alleviate a heat loss when the heater body 700 heats a reaction chamber, with reference to FIG. 5 to FIG. 7, in some embodiments, the support device may further include a thermal insulation member 300, and the thermal insulation member 300 may be sleeved around the plurality of support units 100. Thus, the heat loss when the heater body 700 heats the reaction chamber can be alleviated. The thermal insulation member 300 may be a rigid structure.

Specifically, the thermal insulation member 300 may include a plurality of cambered thermal insulation subunits 310. A position, opposite a support unit 100, of each cambered thermal insulation subunit 310 may be provided with a second mounting groove 311 extending in the first axial direction, and each support unit 100 may be located in a corresponding second mounting groove 311.

In the support device according to the embodiment of the present disclosure, by arranging the thermal insulation member 300 as a structure including the plurality of cambered thermal insulation subunits 310, the thermal insulation member 300 is mounted conveniently, and arrangement methods of the thermal insulation member 300 are more flexible. By sleeving the second mounting groove 311 around the corresponding support unit 100, mounting of the thermal insulation member 300 is facilitated, and structural compactness of the support device is facilitated.

To prevent the thermal insulation member 300 from moving the plurality of insulating support bodies 110 in the support unit 100 due to thermal expansion and contraction after heating and further affecting the connection stability of the plurality of insulating support bodies 110, in some embodiments, a gap may be provided between the support unit 100 and the second mounting groove 311.

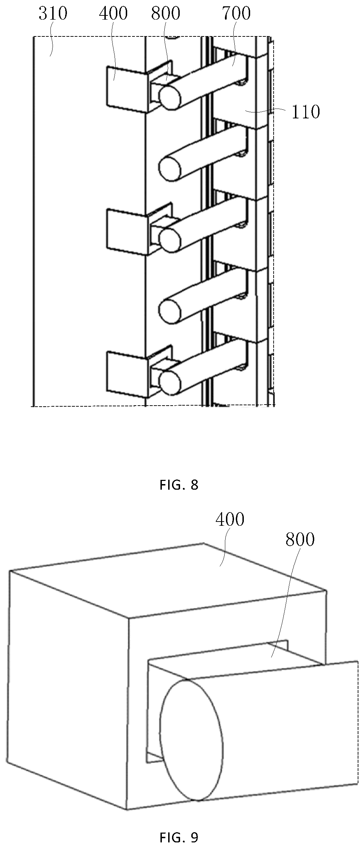

To better support the heater body 700 and prevent the heater body 700 from being substantially deformed under the action of gravity, with reference to FIG. 8 to FIG. 9, in some embodiments, the heater may further include sliding portions 800, and each sliding portion 800 may be connected to the heater body 700. For example, the sliding portion 800 may be welded to the heater body 700. The support device may further include a sliding engagement portion 400, the sliding engagement portion 400 may be arranged at the cambered thermal insulation subunit 310. The sliding engagement portion 400 may be provided with a sliding hole 410, and the sliding portion 800 and the sliding hole 410 are in sliding engagement. The sliding portion 800 and the sliding hole 410 may be in sliding engagement in a radial direction in which the thermal insulation member 300 is sleeved around the plurality of support units 100, that is, the third axial direction in the embodiment.

In the support device according to the embodiment of the present disclosure, by arranging the sliding engagement portion 400, each sliding engagement portion 400 may be arranged at a corresponding cambered thermal insulation subunit 310, and be provided with the sliding hole 410, and the sliding portion 800 connected to the heater body 700 and the sliding hole 410 may be in sliding engagement, and may be in supporting engagement in the first axial direction. Thus, the heater body 700 can be well supported, supporting points for the heater body 700 are increased, and the heater body 700 is prevented from being substantially deformed under the action of gravity. In addition, the sliding portion 800 and the sliding hole 410 are in sliding engagement, to better adapt to the thermal expansion and contraction deformation of the heater body 700.

Specifically, the cambered thermal insulation subunit 310 may be provided with an opening, and the sliding engagement portion 400 may be arranged in the opening. The sliding engagement portion 400 may be bonded to the opening, which is not limitative. The sliding engagement portion 400 is arranged in the opening, to make the mounting of the sliding engagement portion 400 more stable.

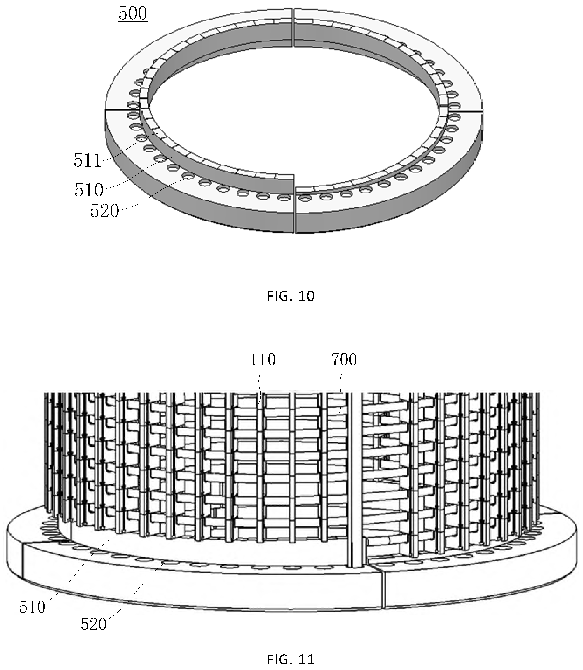

With reference to FIG. 10 to FIG. 12, in some embodiments, the heater body 700 may have a spiral structure. The support device may further include a support base 500, and the support base 500 may have an annular stepped structure 510. A spiral angle formed by a connecting line of center points of stepped surfaces 511 of the annular stepped structure 510 may be equal to the spiral angle of the spiral structure of the heater body 700, and the stepped surface 511 of the annular stepped structure 510 is configured to support the support unit 100. Thus, the insulating support bodies 110 at the same position among the plurality of support units 100 can better support the same spiral segment of the heater body 700, it is unnecessary to arrange insulating support bodies 110 having different heights to adapt to the spiral structure of the heater body 700, and the structure of the support device is simplified advantageously.

In some embodiments, in a case that the support device includes the mounting guide rails 200 extending in the first axial direction, a bottom of each mounting guide rail 200 is mounted in a mounting hole 520 of the support base 500. Thus, the mounting guide rail 200 is mounted more stably.

In some embodiments, the support device may further include a top support member 910. Tops of the insulating support bodies 110 of the plurality of support units 100 are connected through the top support member 910. The top support member 910 may be made of a corundum material, such that a strength and bending resistance of the top support member 910 can be improved. The top support member 910 may be further made of other materials clearly, and the material of the top support member 910 is not specifically limited by the embodiments of the present disclosure.

The present disclosure further discloses a heater. The heater includes a heater body 700 and the support device disclosed in the embodiment. The heater disclosed can avoid the problem that the support device causes deformation of the heater body 700 after thermal expansion and contraction deformation.

A specific assembly process of the heater includes: firstly, the heater body 700 is mounted on a heater support fixture in advance, and mounting gaps of the insulating support bodies 110 are reserved in the heater support fixture. When the same support unit 100 is mounted, one insulating support body 110 is mounted to a preset position from the gap of the heater body 700, another insulating support body 110 is mounted to the gap of an adjacent heater body 700, and the two insulating support bodies 110 are connected through the first limiting portion and the second limiting portion. Then, the mounting guide rail 200 and the thermal insulation member 300 are mounted, and finally the heater body support fixture is removed.

The present disclosure further discloses a semiconductor process apparatus. The semiconductor process apparatus disclosed includes a reaction chamber and the heater disclosed in the embodiment, and the heater is configured to heat the reaction chamber.

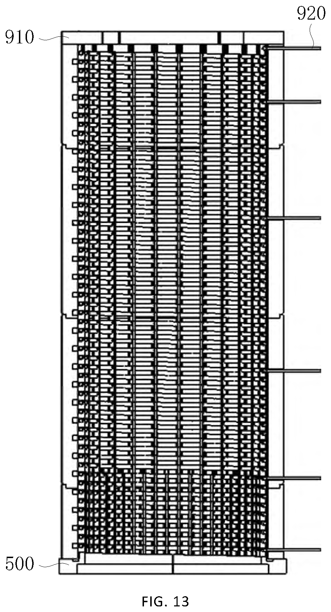

With reference to FIG. 13, the heater may further include a lead terminal 920. The one end of the lead terminal 920 is connected to the heater body 700, and the other end of the lead terminal is connected to a power supply system. The lead terminal 920 transmits electric energy to the heater body 700, and the heater body 700 converts the electric energy into heat energy.

In the semiconductor process apparatus according to the embodiment of the present disclosure, by arranging the heater disclosed in the embodiment, the problem that the support device causes deformation of the heater body after thermal expansion and contraction deformation can be avoided.

The embodiments of the present disclosure focus on differences among the embodiments, and the different optimization features of the embodiments can be combined to form a better embodiment as long as they are not contradictory, which is not repeated herein for the convenience of brevity of the text.

The embodiments of the present disclosure are described above with reference to the accompanying drawings, but the present disclosure is not limited to the above particular implementations, which are merely illustrative rather than restrictive. Under the inspiration of the present disclosure, those of ordinary skill in the art can make many forms without departing from the purposes of the present disclosure and the protection scope of the claims, which should fall within the protection scope of the present disclosure.

## Claims

1. A support device, applied to a heater of a semiconductor process apparatus, to support a heater body of the heater, wherein the support device comprises a plurality of support units; the plurality of support units are arranged circumferentially, and each support unit comprises a plurality of insulating support bodies sequentially stacked; and a first end portion of each insulating support body is provided with a first limiting portion, and a second end portion, oriented away from the first end portion, of the insulating support body is provided with a second limiting portion; and
in each support unit, the first limiting portion of one of any two adjacent insulating support bodies and the second limiting portion of the other of the two adjacent insulating support bodies are in limiting engagement in a first axial direction, and each insulating support body is configured for supporting engagement with the heater body, wherein the first axial direction is parallel to a stacking direction of the plurality of insulating support bodies.

2. The support device according to claim 1, wherein in each support unit, the first limiting portion of one of any two adjacent insulating support bodies and the second limiting portion of the other of the two adjacent insulating support bodies are in inserting engagement in a second axial direction, and the first limiting portion and the second limiting portion are further in limiting engagement in a third axial direction, wherein the third axial direction is parallel to a direction in which a corresponding insulating support body points towards a center of circumferential arrangement of the plurality of support units, and the first axial direction, the second axial direction, and the third axial direction are perpendicular to one another.

3. The support device according to claim 2, wherein each insulating support body is provided with, in the first axial direction, a support recess having an upward opening, and a bottom of the support recess is configured to support the heater body.

4. The support device according to claim 3, wherein in each support unit, the second end portion of any insulating support body blocks the opening of the support recess of an adjacent insulating support body.

5. The support device according to claim 3, wherein the support recess is a strip-shaped recess structure, and an extension direction of the strip-shaped recess structure is parallel to the third axial direction corresponding to the corresponding insulating support body.

6. The support device according to claim 1, wherein the heater body has a spiral structure, and an inclination angle of a support surface, supporting the heater body, of each insulating support body is equal to a spiral angle of the spiral structure.

7. The support device according to claim 1, wherein the first limiting portion is a first limiting protrusion, the second limiting portion is a first limiting groove, and a deformation gap is provided between the first limiting protrusion and the first limiting groove.

8. The support device according to claim 1, further comprising mounting guide rails extending in the first axial direction, wherein each insulating support body comprises a guide rail engagement portion, the plurality of insulating support bodies of each support unit are mounted on a same mounting guide rail in the first axial direction through guide rail engagement portions, and the guide rail engagement portions and the mounting guide rail are in limiting engagement in a preset plane, wherein the preset plane is perpendicular to the first axial direction.

9. The support device according to claim 8, wherein each mounting guide rail is provided with a first mounting groove extending in the first axial direction, and the mounting guide rail comprises a third limiting portion; each guide rail engagement portion comprises a fourth limiting portion, and the guide rail engagement portion and the first mounting groove are in inserting engagement in the first axial direction; and the third limiting portion and the fourth limiting portion are in limiting engagement in a direction from a bottom of the first mounting groove to an opening of the first mounting groove.

10. The support device according to claim 1, further comprising a thermal insulation member, wherein the thermal insulation member is sleeved around the plurality of support units.

11. The support device according to claim 10, wherein the thermal insulation member comprises a plurality of cambered thermal insulation subunits; a position, opposite a support unit, of each cambered thermal insulation subunit is provided with a second mounting groove extending in the first axial direction, and each support unit is located in a corresponding second mounting groove; and a gap is provided between the support unit and the second mounting groove.

12. The support device according to claim 11, wherein the heater further comprises sliding portions, and each sliding portion is connected to the heater body; the support device further comprises sliding engagement portions, and each sliding engagement portion is arranged at a corresponding cambered thermal insulation subunit; and each sliding engagement portion is provided with a sliding hole, and each sliding portion and a corresponding sliding hole are in sliding engagement.

13. The support device according to any one of claims 1 to 12, wherein the heater body has the spiral structure; the support device further comprises a support base, and the support base has an annular stepped structure; and a spiral angle formed by a connecting line of center points of stepped surfaces of the annular stepped structure is equal to the spiral angle of the spiral structure of the heater body, and each stepped surface of the annular stepped structure is configured to support a corresponding support unit.

14. The support device according to claim 13, wherein in a case that the support device comprises the mounting guide rails extending in the first axial direction, a bottom of each mounting guide rail is mounted in a mounting hole of the support base.

15. A heater, comprising a heater body and the support device according to any one of claims 1 to 14.

16. A semiconductor process apparatus, comprising a reaction chamber and the heater according to claim 15, wherein the heater is configured to heat the reaction chamber.
